# EUROPÄISCHE PATENTSCHRIFT

(11) **EP 3 589 103 B1**
(45) Veröffentlichungstag und Bekanntmachung des Hinweises auf die Patenterteilung: **02.03.2022**
(21) Anmeldenummer: 19181917.6
(22) Anmeldetag: 24.06.2019
(51) Int. Cl.: H05K 7/20

(54) **STROMRICHTER FÜR EIN ELEKTRISCH ANTREIBBARES FAHRZEUG**
INVERTER FOR AN ELECTRICALLY DRIVEN VEHICLE
CONVERTISSEUR DE PUISSANCE POUR UN VÉHICULE ÉLECTRIQUE

(30) Priorität: 27.06.2018 DE 102018115515
(43) Veröffentlichungstag der Anmeldung: 01.01.2020
(73) Patentinhaber: Valeo Siemens eAutomotive Germany GmbH, 91056 Erlangen (DE)
(72) Erfinder: EDELHÄUSER, Rainer, 90411 Nürnberg (DE); HÜBNER, Maximilian, 91054 Erlangen (DE); WINTERLING, Michael, 90571 Schwaig b. Nürnberg (DE); PFEIFFER, Kay, 91058 Erlangen (DE)
(74) Vertreter: Dr. Gassner & Partner mbB

(56) Entgegenhaltungen:
- DE-B3-102010 043 446
- DE-B3-102013 109 592
- US-A1- 2010 053 889

## Beschreibung

Die vorliegende Erfindung betrifft einen Stromrichter für ein elektrisch antreibbares Fahrzeug, umfassend drei Leistungshalbleitermodule mit zwei Schaltelementen und einem Trägerelement, das eine Oberseite, auf der die Schaltelemente angeordnet sind, eine der Oberseite gegenüberliegende Unterseite und Seitenflächen, welche die Oberseite und die Unterseite umlaufend verbinden, aufweist, und eine Kühleinrichtung mit einem Kühlkanal, durch den ein Kühlfluid entlang der Unterseite eines jeweiligen Trägerelements führbar ist, einer Aufnahmevorrichtung, in der die Leistungshalbleitermodule derart nebeneinander angeordnet sind, dass sich Seitenflächen eines Paares benachbarter Leistungshalbleitermodule gegenüberliegen, einer Dichtungsvorrichtung, die ein Herausdringen des Kühlfluids aus der Kühleinrichtung verhindert, und einer Anpressvorrichtung, die durch Verspannen mit der Aufnahmevorrichtung eine Anpresskraft auf die Dichtungsvorrichtung ausübt.

Das Dokument US 2010/0053889 A1 offenbart ein Leistungshalbleitermodul mit einem Leistungselektroniksubstrat, das zwischen zwei miteinander verschweißten Kunststoffrahmen aufgenommen ist, wobei zusätzlich eine Dichtung für das Substrat vorhanden ist.

Die DE 10 2013 109 592 B3 schlägt eine Leistungshalbleitereinrichtung mit einem Leistungshalbleitermodul und einem Kühlkörper vor, der zur Abgabe von Wärme an eine Kühlflüssigkeit ausgebildet ist.

Aus der DE 10 2010 043 446 B3 ist ein Leistungshalbleitersystem mit einem Leitungssystem für eine Kühlflüssigkeit bekannt. Ein mit Leistungshalbleitern bestücktes Substrat ist elektrisch isoliert auf einem Kühlkörper angeordnet, der senkrecht abstehende Stifte aufweist, die von der Kühlflüssigkeit umspült werden.

Aus dem Stand der Technik ist ein solcher Stromrichter bekannt, bei dem die Aufnahmevorrichtung durch mehrere Stege gebildet ist, die jeweils das Paar benachbarter Leistungshalbleitermodule über dem Kühlkanal abstützen und unter denen das Kühlfluid durch den Kühlkanal fließt. Die Dichtungsvorrichtung umfasst dabei ein einzelnes Dichtelement für jedes Leistungshalbleitermodul, das sich geschlossen abschnittsweise entlang eines oder mehrerer Stege erstreckt. Der Kühlkanal wird auf seiner den Leistungshalbleitermodulen abgewandten Seite durch ein Deckelelement begrenzt, das an der Aufnahmevorrichtung befestigt ist. Das Kühlfluid fließt mithin während des Betriebs des Stromrichters durch einen jeweiligen zwischen einem Steg und dem Deckelelement ausgebildeten Abschnitt des Kühlkanals.

Ein solcher zweiteiliger Aufbau der Kühleinrichtung verursacht einen hohen Bauteil- und Montageaufwand, da die Aufnahmevorrichtung und das Deckelelement als separate Teile gefertigt und anschließend aneinander montiert werden müssen. Dies ist insbesondere im Hinblick auf den Einsatz des Stromrichters in einem elektrisch antreibbaren Fahrzeug unter Kostengesichtspunkten unerwünscht.

Der Erfindung liegt mithin die Aufgabe zugrunde, einen Stromrichter für ein elektrisch antreibbares Fahrzeug mit einer aufwandsärmer zu realisierenden Kühleinrichtung anzugeben.

Diese Aufgabe wird erfindungsgemäß beim Stromrichter der eingangs genannten Art dadurch gelöst, dass die Kühleinrichtung Stützvorrichtungen aufweist, die jeweils einem der Paare zugeordnet sind und das Paar gegen einen Boden des Kühlkanals beim Einwirken der Anpresskraft abstützen, wobei jede Stützvorrichtung mehrere Stützelemente aufweist, die entlang der gegenüberliegenden Seitenflächen des Paars angeordnet sind und sich jeweils innerhalb des Kühlkanals vom Boden bis zu den Unterseiten des Paars erstrecken, sodass jeweils zwei benachbarte Stützelemente und der Boden abschnittsweise Teilkühlkanäle des Kühlkanals begrenzen.

Die Erfindung schlägt mithin vor, dass die benötigte Anpresskraft nicht auf einen einzigen Steg, sondern auf eine Vielzahl von Stützelementen ausgeübt wird, die sich vom Boden des Kühlkanals aus erstrecken. Der Kühlkanal wird so im Bereich der nebeneinander liegenden Leistungshalbleitermodule in mehrere Teilkühlkanäle geteilt, durch die das Kühlfluid beim Passieren eines jeweiligen Leistungshalbleitermoduls fließen kann. Mit anderen Worten werden innerhalb des Kühlkanals durch die Stützelemente Inseln ausgebildet, welche die Anpresskraft zum Abdichten der Kühleinrichtung auf den Boden des Kühlkanals leiten.

Mit Vorteil kann so auf das aufwendige Gießen von sich parallel zu den gegenüberliegenden Seitenflächen erstreckenden Stegen verzichtet werden, was den Fertigungsaufwand der Kühlrichtung erheblich verringert. Außerdem kann der Boden integral mit der Aufnahmevorrichtung ausgebildet werden, so dass auf eine zweiteilige Ausgestaltung der Kühleinrichtung verzichtet werden kann. Dies erspart den Montageaufwand für das Anbringen eines den Boden ausbildenden Deckelelements.

Der erfindungsgemäße Stromrichter ist typischerweise dazu eingerichtet, eine von einer Hochvoltbatterie des Fahrzeugs bereitgestellte Gleichspannung in eine mehrphasige Wechselspannung zum Versorgen eines Elektromotors des Fahrzeugs zu wandeln. Die Schaltelemente eines jeweiligen Leistungshalbleitermoduls können Halbbrücken ausbilden, an deren Mittelabgriff ein Phasenstrom für den Elektromotor bereitstellbar ist. Es können auch mehr als drei Leistungshalbleitermodule, beispielsweise sechs Leistungshalbleitermodule, zur Bereitstellung eines entsprechenden mehrphasigen Wechselstroms vorgesehen sein.

Die Unterseite eines jeweiligen Trägerelements ist bevorzugt durch einen Kühlkörper ausgebildet, der durch das Kühlfluid umströmbar ist. Der Kühlkörper kann eine Kühlplatte und sich von dieser in den Kühlkanal erstreckende Kühlelemente, beispielsweise eine Vielzahl von Pinfins, aufweisen. Die Aufnahmevorrichtung weist typischerweise eine Ausnehmung auf, welche die nicht durch die Stützvorrichtungen abgestützten Ränder der Unterseite eines jeweiligen Trägerelements abstützt.

Die Anpressvorrichtung ist zweckmäßigerweise rahmenartig ausgebildet und liegt Rändern der Oberseite eines jeweiligen Trägerelements abschnittsweise gegenüber. Jede Stützvorrichtung kann wenigstens drei, bevorzugt wenigstens sechs, besonders bevorzugt wenigstens neun, Stützelemente aufweisen. Jedes Stützelement kann bezüglich einer Flussrichtung des Kühlfluids länglich, insbesondere mit spitz zulaufenden Enden, ausgebildet sein, um die Stützvorrichtung strömungsmechanisch zu optimieren.

Es wird bei dem erfindungsgemäßen Stromrichter bevorzugt, dass die Stützelemente jeweils leistungshalbleitermodulseitig eine Ausnehmung aufweisen.

Ferner kann jede Stützvorrichtung ein die Stützelemente leistungshalbleitermodulseitig verbindendes Verbindungselement aufweisen, so dass die Teilkühlkanäle zusätzlich durch das Verbindungselement begrenzt sind. Bevorzugt sind die Stützelemente einerseits und das Verbindungselement andererseits mehrteilig ausgebildet. Das Verbindungselement kann durch einen Blechstreifen oder durch einen Kunststoffstreifen ausgebildet sein. Es ist von besonderem Vorteil, wenn das Verbindungselement in die Ausnehmung eingesetzt ist, da eine Ausbildung des die Teilkühlkanäle begrenzenden Verbindungselements durch ein Gussverfahren aufwendig ist.

Gemäß einer bevorzugten Ausführungsform des erfindungsgemäßen Stromrichters ist die Dichtungsvorrichtung zwischen den Stützelementen und den Leistungshalbleitermodulen angeordnet. Die Dichtungsvorrichtung kann beispielsweise auf dem Verbindungselement angeordnet sein. Dadurch wird ermöglicht, dass die Dichtungsvorrichtung, insbesondere bei einer vollständig elastischen Ausbildung, nicht in die Teilkühlkanäle hineingedrückt wird. Dies gilt insbesondere im Hinblick darauf, dass der Kühlkanal vor einer Befüllung mit dem Kühlfluid evakuiert wird, so dass der dabei entstehende Unterdruck die Dichtungsvorrichtung in die Teilkühlkanäle hineinzieht und sich die Dichtungsvorrichtung dadurch verformt. Typischerweise ist das Verbindungselement steifer als die Dichtungsvorrichtung ausgebildet.

Außerdem kann auch die Aufnahmevorrichtung für jede Stützvorrichtung zwei weitere Ausnehmungen, die insbesondere tiefer als die zuvor genannten Ausnehmung der Aufnahmevorrichtung sind, aufweisen, wobei das Verbindungselement in die Ausnehmungen der Aufnahmevorrichtung eingesetzt ist. Dadurch wird das Verbindungselement optimal über seine gesamte Erstreckung abgestützt.

Bei einer weiteren bevorzugten Ausführungsform des erfindungsgemäßen Stromrichters ist vorgesehen, dass die Dichtungsvorrichtung zwischen den Leistungshalbleitermodulen und der Anpressvorrichtung angeordnet ist. In diesem Fall liegen die Ränder der Unterseiten typischerweise unmittelbar auf den Stützelementen auf. Allerdings können auch hier Ausnehmungen und/oder Verbindungselemente wie zuvor beschrieben vorgesehen sein. Die Dichtungsvorrichtung kann die Ränder der Oberseite der Trägerelemente vollständig abdecken und auf diesen und der Aufnahmevorrichtung aufliegen.

Bei dem erfindungsgemäßen Stromrichter sind die Stützelemente bevorzugt fest mit dem Boden verbunden. Im Hinblick auf die Herstellung der Kühleinrichtung durch ein Gussverfahren wird es bevorzugt, wenn die Stützelemente integral mit dem Boden ausgebildet sind.

Im Rahmen einer weiteren Ausführungsform des verbindungsgemäßen Stromrichters sind die Stützvorrichtungen integral mit der Dichtungsvorrichtung ausgebildet. Das heißt, dass die zwischen den Trägerelementen und dem Boden angeordnete Dichtungsvorrichtung selbst die Stützelemente realisiert.

Hinsichtlich der Dichtungsvorrichtung kann bei dem erfindungsgemäßen Stromrichter vorgesehen sein, dass diese eine steife Lage, auf der einseitig oder beidseitig eine elastische Dichtlage angeordnet ist, aufweist. Dies ist insbesondere zweckmäßig, wenn die Dichtungsvorrichtung unmittelbar, also ohne die Verbindungselemente, in die Ausnehmungen der Stützelemente eingesetzt ist. Die steife Lage kann durch ein in die Dichtungsvorrichtung integriertes Teil, das steifer als die elastische Dichtlage ist, oder durch eine geeignete Gestaltung, insbesondere Formgebung, der Dichtungsvorrichtung, ausgebildet sein.

Außerdem ist es möglich, dass die Dichtungsvorrichtung kühlkanalseitig eine andere Oberflächenkontur als auf ihrer den Leistungshalbleitermodulen zugewandte Seite aufweist. So kann vorgesehen sein, dass die den Leistungshalbleitermodulen zugewandte Seite eine an den Rand der Unterseite angepasste Oberflächenkontur aufweist. Typischerweise ist die Dichtungsvorrichtung kühlkanalseitig mit einer einheitlichen Dichtkontur ausgebildet.

Die Dichtungsvorrichtung kann eine Feststoffdichtung oder eine ausgehärtete Flüssigdichtung umfassen. Die Verwendung einer Flüssigdichtung ermöglicht es, eine Dichtflüssigkeit auf das Verbindungselement aufzubringen, so dass sich die Dichtungsvorrichtung an die Form der Leistungshalbleitermodule anpasst. Ebenso kann die Dichtflüssigkeit auf die Oberseite eines jeweiligen Trägerelements aufgebracht werden, um Zwischenräume zwischen der Aufnahmevorrichtung und den Leistungshalbleitermodulen sowie zwischen den Leistungshalbleitermodulen untereinander optimal auszufüllen.

Bevorzugt ist die Dichtungsvorrichtung als zusammenhängendes Dichtelement mit einer der Anzahl der Leistungshalbleitermodule entsprechenden Anzahl von Löchern ausgebildet. So kann das Anbringen bzw. Ausbilden der Dichtungsvorrichtung im Vergleich zu der Verwendung von einzelnen Dichtelementen erheblich vereinfacht werden.

Schließlich wird es bei dem erfindungsgemäßen Stromrichter bevorzugt, wenn der Boden wannenartig in einem Gehäuse des Stromrichters ausgebildet ist. Das Gehäuse lässt sich so besonders einfach als Gussteil herstellen.

Weitere Vorteile und Einzelheiten der Erfindung ergeben sich aus den im Folgenden beschriebenen Ausführungsbeispielen sowie anhand der Zeichnungen. Diese sind schematische Darstellungen und zeigen:
- Fig. 1: eine Prinzipskizze eines elektrisch antreibbaren Fahrzeugs mit einem Ausführungsbeispiel eines erfindungsgemäßen Stromrichters;
- Fig. 2: einen Abschnitt eines Gehäuses des Stromrichters mit Leistungshalbleitermodulen und einer Kühleinrichtung im montierten Zustand;
- Fig. 3: den in Fig. 2 gezeigten Abschnitt des Gehäuses mit einem freigelegten Kühlkanal;
- Fig. 4: den in Fig. 2 gezeigten Abschnitt des Gehäuses mit eingesetzten Verbindungselementen;
- Fig. 5: den in Fig. 2 gezeigten Abschnitt des Gehäuses mit einer Dichtungsvorrichtung;
- Fig. 6: den in Fig. 2 gezeigten Abschnitt des Gehäuses mit eingesetzten Leistungshalbleitermodulen;
- Fig. 7: ein Abschnitt eines Gehäuses eines weiteren Ausführungsbeispiels des erfindungsgemäßen Stromrichters mit freigelegtem Kühlkanal;
- Fig. 8: den in Fig. 7 gezeigten Abschnitt des Gehäuses mit eingesetzten Leistungshalbleitermodulen und einer Dichtungsvorrichtung; und
- Fig. 9: den in Fig. 7 gezeigten Abschnitt des Gehäuses mit einer Kühleinrichtung im montierten Zustand.

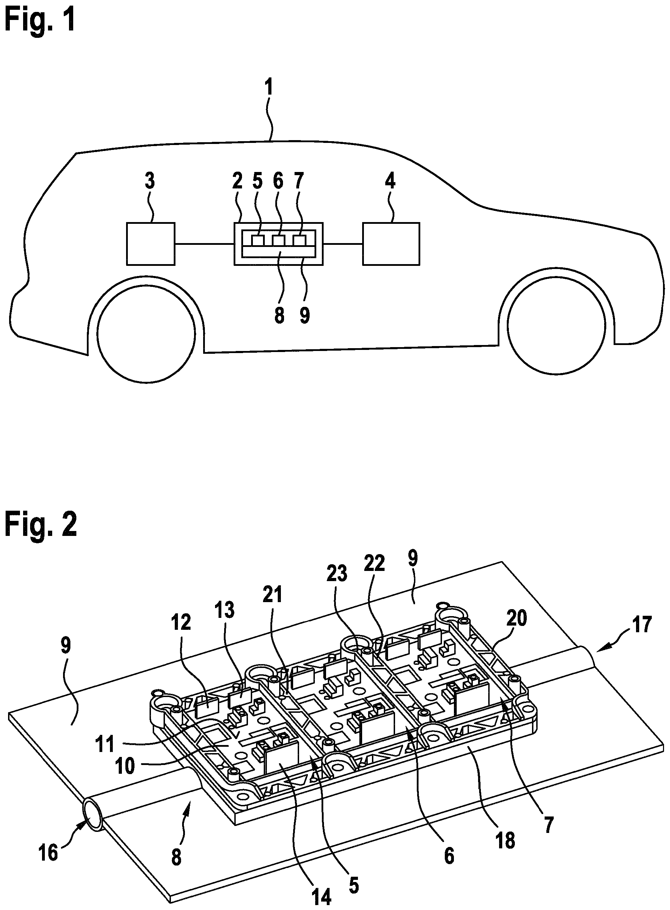

Fig. 1 ist eine Prinzipskizze eines elektrisch antreibbaren Fahrzeugs 1 mit einem Ausführungsbeispiel eines Stromrichters 2. Der Stromrichter 2 ist dazu eingerichtet, eine von einer Hochvoltbatterie 3 bereitgestellte Gleichspannung in einen mehrphasigen, hier dreiphasigen, Wechselstrom zur Versorgung eines Elektromotors 4, welcher das Fahrzeug 1 antreibt, zu wandeln.

Der Stromrichter 2 umfasst drei Leistungshalbleitermodule 5, 6, 7 und eine Kühleinrichtung 8, die dazu eingerichtet ist, während des Betriebs des Stromrichters 2 in den Leistungshalbleitermodulen erzeugte Wärme abzuführen. Im vorliegenden Ausführungsbeispiel ist die Kühleinrichtung in ein Gehäuse 9 des Stromrichters 2 integriert.

Fig. 2 ist eine perspektivische Ansicht eines Abschnitts des Gehäuses 9 mit den Leistungshalbleitermodulen 5, 6, 7 und der Kühleinrichtung 8.

Jedes der Leistungshalbleitermodule 5, 6, 7 umfasst zwei Schaltelemente, beispielsweise IGBT oder Leistungs-MOSFET, und ein Trägerelement 10. Das Trägerelement 10 umfasst eine Oberseite 11, auf der Anschlüsse 12, 13, 14 zum Kontaktieren der Schaltelemente angeordnet sind. Ferner umfasst das Trägerelement 10 eine in den Zeichnungen verdeckte, der Oberseite 11 gegenüberliegende Unterseite und ebenso verdeckte Seitenflächen, welche die Oberseite 10 und die Unterseite umlaufend verbinden.

Die Schaltelemente sind zu Halbbrücken verschaltet, sodass der Anschluss 12 mit einem positiven Potenzial der Hochvoltbatterie 3 und der Anschluss 13 mit einem negativen Potenzial der Hochvoltbatterie 3 verbindbar sind. Der Anschluss 14 kontaktiert einen Mittelabgriff zwischen den Schaltelementen, um einen Phasenstrom für den Elektromotor 4 bereitzustellen.

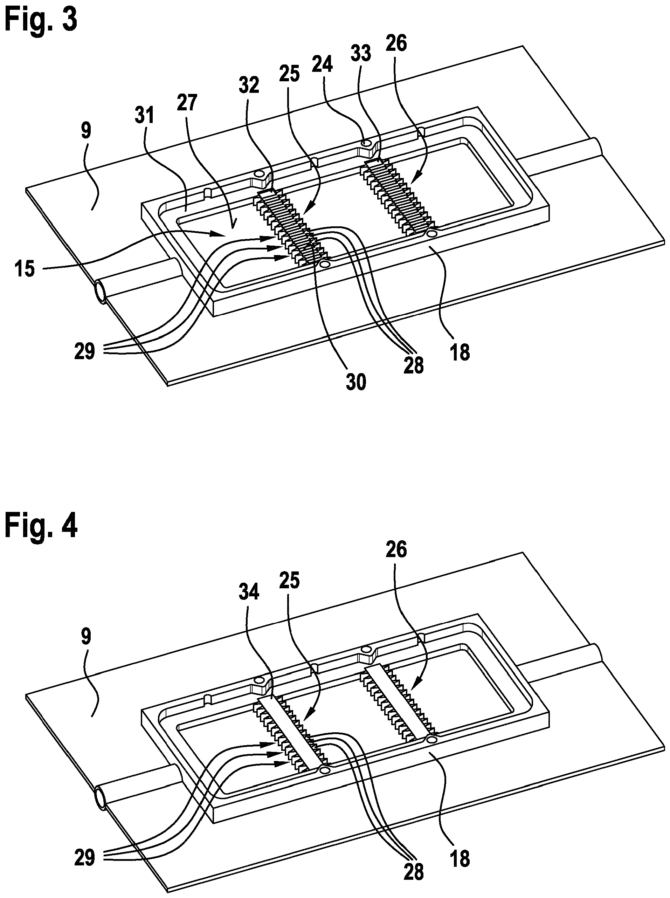

Die Kühleinrichtung 8 umfasst einen in Fig. 2 durch die Leistungshalbleitermodule 5, 6, 7 verdeckten Kühlkanal 15 (vgl. Fig. 3 bis 5), durch den ein Kühlfluid entlang der Unterseite eines jeweiligen Trägerelements 10 führbar ist. Daneben zeigt Fig. 2 einen Kühlfluideinlass 16 und einen Kühlfluidauslass 17, die in das Gehäuse 9 integriert und fluidleitend mit dem Kühlkanal 15 verbunden sind.

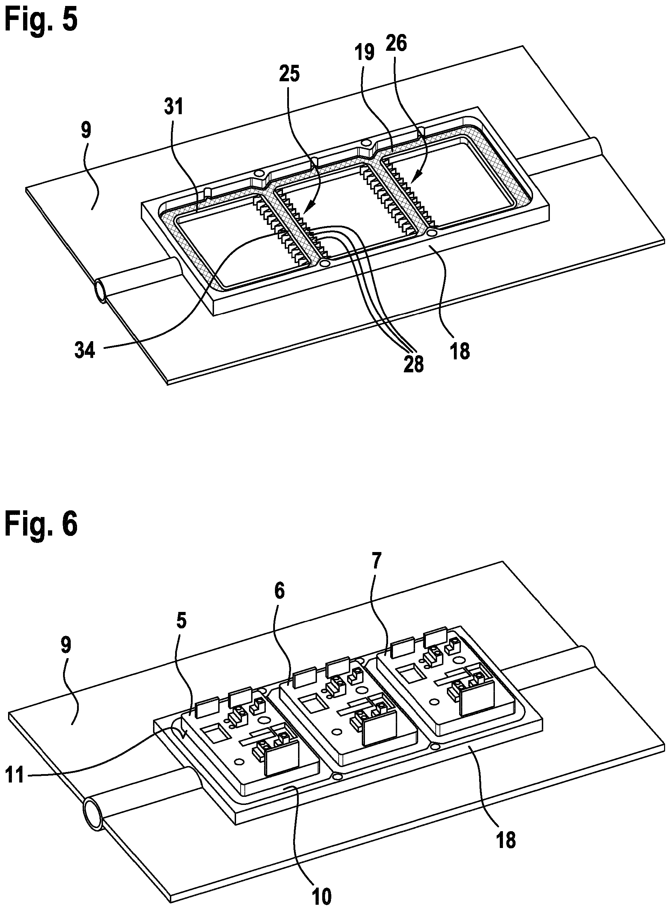

Daneben weist die Kühleinrichtung 8 eine Aufnahmevorrichtung 18 auf, in welcher die Leistungshalbleitermodule 5, 6, 7 derart nebeneinander angeordnet sind, dass sich Seitenflächen eines Paars benachbarter Halbleitermodule 5, 6, 7 gegenüber liegen. Ersichtlich bilden die Leistungshalbleitermodule 5, 6 einerseits und die Leistungshalbleitermodule 6, 7 derartige Paare, bei den jeweils eine Seitenfläche eines Trägerelements 10 einer anderen Seitenfläche des Trägerelements 10 des benachbarten Leistungshalbleitermoduls 5, 6, 7 gegenüber liegt. Außerdem umfasst die Kühleinrichtung 8 eine in Fig. 2 ebenfalls verdeckte Dichtungsvorrichtung 19 (siehe Fig. 5), die ein Herausdringen des Kühlfluids aus der Kühleinrichtung 8 verhindert.

Schließlich ist eine Anpressvorrichtung 20 vorgesehen, die durch Verspannen mit der Aufnahmevorrichtung 18 eine Anpresskraft auf die Dichtungsvorrichtung 19 ausübt. Die Anpressvorrichtung 20 ist rahmenartig ausgebildet und umfasst zwei Stege 21, 22, die sich entlang der gegenüberliegenden Seitenflächen der Paare benachbarter Leistungshalbleitermodule 5, 6, 7 erstrecken. Die Anpressvorrichtung 20 liegt auf Rändern der Oberseiten 11 sowie auf der Aufnahmevorrichtung 18 auf. Die Anpressvorrichtung 20 umfasst ferner mehrere Befestigungslöcher 23, durch die nicht gezeigte Befestigungsmittel in korrespondierender Löcher 24 (vgl. Fig. 3 bis 6) der Aufnahmevorrichtung 18 zum Verspannen eingeführt sind.

Die Fig. 3 bis 6 sind jeweils perspektivische Darstellungen des Abschnitts des Gehäuses 9 in freigelegten Zuständen während eines jeweiligen Schritts der Montage des Stromrichters 2.

In Fig. 3 liegt die Aufnahmevorrichtung 18 vollständig frei, sodass der Kühlkanal 15 sichtbar ist. Die Kühleinrichtung 8 weist eine der Anzahl der Paare benachbarter Leistungshalbleitermodule 5, 6, 7 entsprechende Anzahl an Stützvorrichtungen 25, 26 auf, die jeweils einem der Paare zugeordnet sind und das Paar gegen einen Boden 27 des Kühlkanals 15 beim Einwirken der Anpresskraft abstützen. Jede Stützvorrichtung 25, 26 umfasst mehrere, vorliegend dreizehn, Stützelemente 28, die entlang der gegenüberliegenden Seitenflächen des Paars angeordnet sind und sich jeweils innerhalb des Kühlkanals 15 von dessen Boden 27 bis zu den Unterseiten des Paares erstrecken. Dabei begrenzen jeweils zwei benachbarte Stützelemente 28 einer Stützvorrichtung 25, 26 und der Boden 27 abschnittweise Teilkühlkanäle 29 des Kühlkanals. Die Stützelemente 28 weisen jeweils leistungshalbleitermodulseitig eine Ausnehmung 30 auf und sind integral mit dem Boden 27, beispielsweise durch ein Gussverfahren, ausgebildet.

Die Aufnahmevorrichtung 18 weist ferner eine erste stufenartige Ausnehmung 31 auf, welche Ränder der Unterseite eines jeweiligen Trägerelements 10 abstützen. Für jede Stützvorrichtung umfasst die Aufnahmevorrichtung 18 zwei zweite Ausnehmungen 32, 33, die in der ersten Ausnehmung 31 vorgesehen sind und sich in Richtung der Ausnehmungen 30 einer jeweiligen Stützvorrichtung 25, 26 fortsetzen. In Fig. 3 ist ferner zu erkennen, dass der Boden 27 durch eine wannenartige Ausnehmung im Gehäuse 9 des Stromrichters 2 ausgebildet ist.

In Fig. 4 ist zu erkennen, dass jede Stützvorrichtung 25, 26 ferner ein Verbindungselement 34 aufweist, welches die Stützelemente 28 leistungshalbleitermodulseitig verbindet. Mithin sind die Teilkühlkanäle 29 zusätzlich durch das Verbindungselement 34 begrenzt. Das Verbindungselement 34 ist in die Ausnehmungen 30 der Stützelemente 28 und in die zweiten Ausnehmungen 32, 33 der Aufnahmevorrichtung 18 eingesetzt. Das Verbindungselement 34 ist als schmaler Blech- oder Kunststoffstreifen ausgebildet und schließt bündig mit der ersten Ausnehmung 31 der Aufnahmevorrichtung 18 und mit den Stützelementen 28 ab.

In Fig. 5 ist die Dichtungsvorrichtung 19 derart in die Aufnahmevorrichtung 18 eingesetzt, dass sie auf den Verbindungselementen 34 und der ersten Ausnehmung 31 aufliegt. Ersichtlich ist die Dichtungsvorrichtung 19 als zusammenhängendes Dichtelement mit einer der Anzahl der Leistungshalbleitermodule 5, 6, 7 entsprechenden Anzahl von Löchern ausgebildet. Die Dichtungsvorrichtung 19 ist in diesem Ausführungsbeispiel eine Feststoffdichtung. Alternativ ist die Dichtungsvorrichtung 19 durch eine ausgehärtete Flüssigdichtung gebildet, wozu eine Dichtflüssigkeit entlang der ersten Ausnehmung 31 der Aufnahmevorrichtung 18 und der Verbindungselemente 34 aufgebracht wird. Im eingesetzten bzw. ausgehärteten Zustand liegen mithin sämtliche Randbereiche der Unterseite der Leistungshalbleitermodule 5, 6, 7 auf der Dichtungsvorrichtung 19 auf.

Fig. 5 verdeutlicht den Vorteil der Verbindungselemente 34: Der Kühlkanal 15 wird vor einer Befüllung mit dem Kühlfluid typischerweise vollständig evakuiert. Die Verbindungselemente 34 verhindern dabei, dass die elastische Dichtvorrichtung 19 in die Zwischenräume zwischen den Stützelementen 28 gezogen werden und sich unerwünscht verformen.

In Fig. 6 sind die Leistungshalbleitermodule 5, 6, 7 in die Aufnahmevorrichtung 18 eingesetzt, sodass im Wesentlichen nur die Oberseite 11 des Trägerelements 10 eines jeweiligen Leistungshalbleitermoduls 5, 6, 7 sichtbar ist. In diesem Zustand wird die Anpressvorrichtung 20 auf der Aufnahmevorrichtung 18 und den Oberseiten 11 angeordnet und verspannt, sodass der in Fig. 2 gezeigte montierte Zustand eingenommen wird.

Das Trägerelement 10 eines jeweiligen Leistungshalbleitungsmoduls 5, 6, 7 weist einen die Unterseite bildenden Kühlkörper, der in den Zeichnungen nicht sichtbar ist, auf. Über diesen Kühlkörper ist eine thermisch leitende Verbindung zwischen dem im Kühlkanal 15 fließenden Kühlfluid und den Schaltelementen hergestellt. Der, beispielsweise aus Aluminium gebildete, Kühlkörper weist zudem eine Vielzahl von Vorsprüngen, sog. Pinfins, auf, die in den Kühlkanal 15 hineinragen und durch das Kühlfluid umspülbar sind.

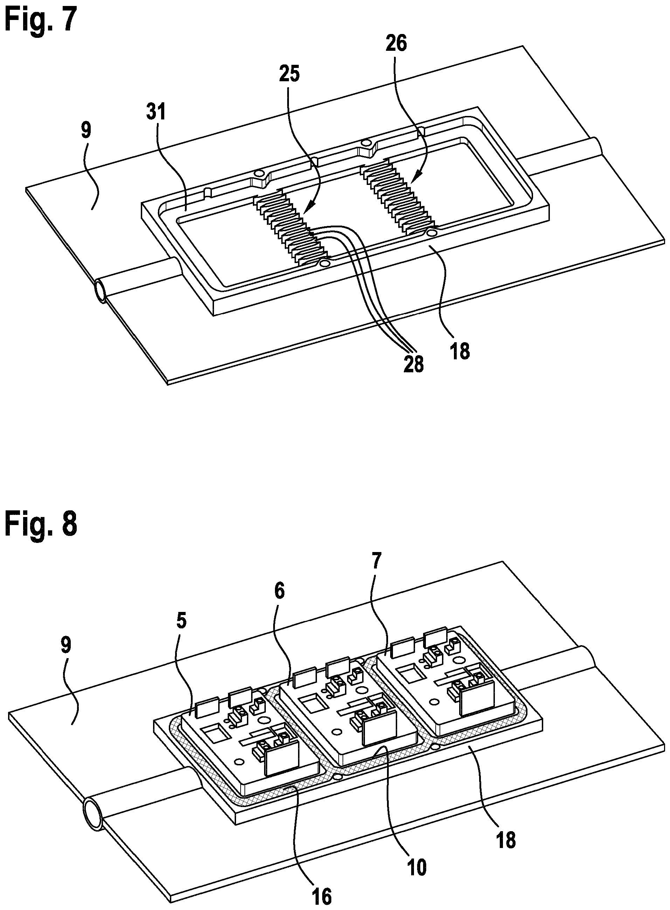

Fig. 7 ist eine perspektivische Ansicht eines Abschnitts eines Gehäuses 9 eines weiteren Ausführungsbeispiels eines Stromrichters, der den zuvor beschriebenen Ausführungsbeispielen entspricht, soweit im Folgenden nichts Abweichendes beschrieben ist. Dabei sind gleiche oder gleichwirkende Komponenten mit identischen Bezugszeichen versehen.

Fig. 7 zeigt den Abschnitt des Gehäuses 9 in einem Fig. 3 entsprechenden Zustand während der Montage. Ersichtlich weisen die Stützelemente 28 einer jeweiligen Stützvorrichtung 25, 26 keine Ausnehmungen auf, sondern sind leistungshalbleitermodulseitig eben ausgebildet. Auch fehlen zweite Ausnehmungen bei der Aufnahmevorrichtung 18, so dass die Stützelemente 28 bündig mit der ersten Ausnehmung 31 der Aufnahmevorrichtung 18 abschließen.

Fig. 8 zeigt die unmittelbar auf die Stützvorrichtung 25, 26 und in die Aufnahmevorrichtung 18 eingesetzten Leistungshalbleitermodule 5, 6, 7 und die Dichtungsvorrichtung 16, welche oberseitige Ränder des Trägerelements 10 eines jeweiligen Leistungshalbleitermoduls 5, 6, 7 und die Aufnahmevorrichtung 18 überlappt. Analog zu den zuvor beschriebenen Ausführungsbeispielen kann es sich bei der Dichtungsvorrichtung 16 wiederum um eine ausgehärtete Flüssigdichtung oder um eine Feststoffdichtung handeln.

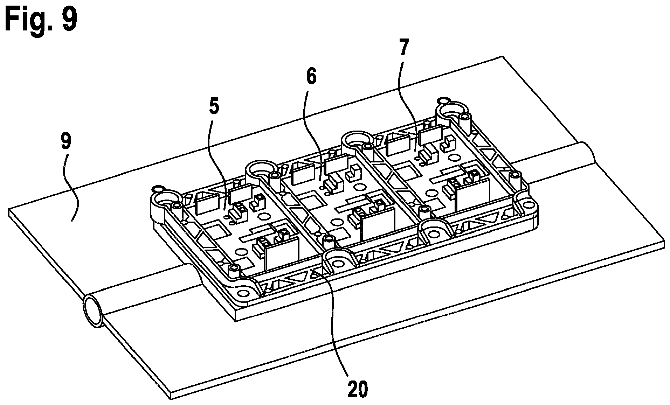

Fig. 9 zeigt den Abschnitt des Gehäuses 9 in einem montierten Zustand. Dabei ist die Anpressvorrichtung 20 unmittelbar auf die Dichtungsvorrichtung 19 aufgesetzt, um die Anpresskraft auf die Dichtungsvorrichtung 19 auszuüben.

Gemäß einem weiteren nicht gezeigten Ausführungsbeispiel, das im Übrigen dem ersten Ausführungsbeispiel entspricht, sind die Stützvorrichtungen 25, 26 nicht integral mit dem Boden 27 ausgebildet, sondern integral mit der Dichtungsvorrichtung 19. Die Dichtungsvorrichtung 19 weist mithin neben dem die Löcher aufweisenden Dichtelement in jedem Bereich, der sich entlang der benachbarten Seitenflächen erstreckt, die Stützelemente 28 ausbildende Vorsprünge auf, die sich bis zum Boden 27 des Kühlkanals 15 erstrecken.

Bei allen zuvor beschriebenen Ausführungsbeispielen kann die Dichtungsvorrichtung eine steife Lage, beispielsweise ein Metallblech, aufweisen, auf der einseitig oder beidseitig eine elastische Dichtlage angeordnet ist. Die Dichtungsvorrichtung 16 erhält so eine ausreichende Eigensteifigkeit, die ein Verformen in Richtung der Zwischenräume zwischen den Stützelementen 28 verhindert, sodass insbesondere im Hinblick auf eine Realisierung gemäß den Fig. 3 und 4 auf die zweiten Ausnehmungen 31, 32 und das Verbindungselement 34 verzichtet werden kann.

## Patentansprüche

1. Stromrichter (2) für ein elektrisch antreibbares Fahrzeug (1), umfassend
- drei Leistungshalbleitermodule (5, 6, 7) mit
(i) zwei Schaltelementen und
(ii) einem Trägerelement (10), das eine Oberseite (11), auf der Anschlüsse (12, 13, 14) zum Kontaktieren der Schaltelemente angeordnet sind, eine der Oberseite (11) gegenüberliegende Unterseite und Seitenflächen, welche die Oberseite (11) und die Unterseite umlaufend verbinden, aufweist, und
- eine Kühleinrichtung (8) mit
(i) einem Kühlkanal (15), durch den ein Kühlfluid entlang der Unterseite eines jeweiligen Trägerelements (10) führbar ist,
(ii) einer Aufnahmevorrichtung (18), in der die Leistungshalbleitermodule (5, 6, 7) derart nebeneinander angeordnet sind, dass sich Seitenflächen eines Paares benachbarter Leistungshalbleitermodule (5, 6, 7) gegenüberliegen,
(iii) einer Dichtungsvorrichtung (19), die ein Herausdringen des Kühlfluids aus der Kühleinrichtung (8) verhindert, und
(iv) einer Anpressvorrichtung (20), die durch Verspannen mit der Aufnahmevorrichtung (18) eine Anpresskraft auf die Dichtungsvorrichtung (19) ausübt,
**dadurch gekennzeichnet,**
**dass** die Kühleinrichtung (8) Stützvorrichtungen (25, 26) aufweist, die jeweils einem der Paare zugeordnet sind und das Paar gegen einen Boden (27) des Kühlkanals (15) beim Einwirken der Anpresskraft abstützen, wobei jede Stützvorrichtung (25, 26) mehrere Stützelemente (28) aufweist, die entlang der gegenüberliegenden Seitenflächen des Paars angeordnet sind und sich jeweils innerhalb des Kühlkanals (15) vom Boden (27) bis zu den Unterseiten des Paars erstrecken, sodass jeweils zwei benachbarte Stützelemente (28) und der Boden (27) abschnittsweise Teilkühlkanäle (29) des Kühlkanals (15) begrenzen.

2. Stromrichter nach Anspruch 1, wobei die Stützelemente (28) jeweils leistungshalbleitermodulseitig eine Ausnehmung (30) aufweisen.

3. Stromrichter nach Anspruch 1 oder 2, wobei jede Stützvorrichtung (25, 26) ein die Stützelemente leistungshalbleitermodulseitig verbindendes Verbindungselement (34) aufweist, sodass die Teilkühlkanäle (29) zusätzlich durch das Verbindungselement (34) begrenzt sind.

4. Stromrichter nach den Ansprüchen 2 und 3, wobei das Verbindungselement (34) in die Ausnehmungen (30) eingesetzt ist.

5. Stromrichter Anspruch 3 oder 4, wobei die Dichtungsvorrichtung (19) auf dem Verbindungselement (34) angeordnet ist.

6. Stromrichter nach einem der Ansprüche 2 bis 5, wobei die Dichtungsvorrichtung (19) in die Ausnehmungen (30) eingesetzt ist.

7. Stromrichter nach einem der Ansprüche 1 bis 4, wobei die Dichtungsvorrichtung (19) zwischen den Leistungshalbleitermodulen (5, 6, 7) und der Anpressvorrichtung (20) angeordnet ist.

8. Stromrichter nach einem der vorhergehenden Ansprüche, wobei die Stützelemente (28) fest mit dem Boden (27) verbunden, insbesondere integral mit dem Boden (27) ausgebildet, sind.

9. Stromrichter nach Ansprüche 1 bis 6, wobei die Stützvorrichtungen (25, 26) integral mit der Dichtungsvorrichtung (19) ausgebildet sind.

10. Stromrichter nach einem der vorhergehenden Ansprüche, wobei die Dichtungsvorrichtung (19) eine steife Lage, auf der einseitig oder beidseitig eine elastische Dichtlage angeordnet ist, aufweist.

11. Stromrichter nach einem der vorhergehenden Ansprüche, wobei die Dichtungsvorrichtung (19) eine Feststoffdichtung oder eine ausgehärtete Flüssigdichtung umfasst.

12. Stromrichter nach einem der vorhergehenden Ansprüche, wobei die Dichtungsvorrichtung (19) als zusammenhängendes Dichtelement mit einer der Anzahl der Leistungshalbleitermodule (5, 6, 7) entsprechenden Anzahl von Löchern ausgebildet ist.

13. Stromrichter nach einem der vorhergehenden Ansprüche, wobei der Boden (27) durch eine Ausnehmung in einem Gehäuse (9) des Stromrichters (2) ausgebildet ist.

## Claims

1. An inverter (2) for an electrically driven vehicle (1), comprising
- three power semiconductor modules (5, 6, 7) with
(i) two switching elements and
(ii) a support element (10) having an upper surface (11) on which terminals (12, 13, 14) for contacting the switching elements are arranged, a lower surface opposite the upper surface (11), and side surfaces circumferentially connecting the upper surface (11) and the lower surface; and
- a cooling device (8) with
(i) a cooling channel (15) through which a cooling fluid can be guided along the underside of a respective carrier element (10),
(ii) a receiving device (18) in which the power semiconductor modules (5, 6, 7) are arranged side by side such that side faces of a pair of adjacent power semiconductor modules (5, 6, 7) face each other,
(iii) a sealing device (19) which prevents the cooling fluid from escaping from the cooling device (8), and
(iv) a pressing device (20) which exerts a pressing force on the sealing device (19) by clamping the receiving device (18),
**characterized in that**
that the cooling device (8) comprises supporting devices (25, 26) each associated with one of the pairs and supporting the pair against a bottom (27) of the cooling channel (15) upon application of the pressing force, each supporting device (25, 26) comprising a plurality of supporting elements (28) arranged along the opposite side surfaces of the pair and each extending within the cooling channel (15) from the bottom (27) to the undersides of the pair, so that in each case two adjacent support elements (28) and the bottom (27) delimit partial cooling channels (29) of the cooling channel (15) in sections.

2. The power converter according to claim 1, wherein the support elements (28) each comprise a recess (30) on the power semiconductor module side.

3. The power converter according to claim 1 or 2, wherein each supporting device (25, 26) has a connecting element (34) connecting the supporting elements on the power semiconductor module side, so that the partial cooling channels (29) are additionally delimited by the connecting element (34).

4. The power converter according to claims 2 and 3, wherein the connecting element (34) is inserted into the recesses (30).

5. The power converter according to claim 3 or 4, wherein the sealing device (19) is arranged on the connecting element (34).

6. The power converter according to any one of claims 2 to 5, wherein the sealing device (19) is inserted into the recesses (30).

7. The power converter according to any one of claims 1 to 4, wherein the sealing device (19) is arranged between the power semiconductor modules (5, 6, 7) and the pressing device (20).

8. The power converter according to any one of the preceding claims, wherein the support elements (28) are fixedly connected to the base (27), in particular integrally formed with the base (27).

9. The power converter according to any one of claims 1 to 6, wherein the support devices (25, 26) are integrally formed with the sealing device (19).

10. The power converter according to any one of the preceding claims, wherein the sealing device (19) comprises a rigid layer on which an elastic sealing layer is arranged on one or both sides.

11. The power converter according to any one of the preceding claims, wherein the sealing device (19) comprises a solid seal or a cured liquid seal.

12. The power converter according to any one of the preceding claims, wherein the sealing device (19) is formed as a continuous sealing element with a number of holes corresponding to the number of power semiconductor modules (5, 6, 7).

13. The power converter according to any one of the preceding claims, wherein the bottom (27) is formed by a recess in a housing (9) of the converter (2).

## Revendications

1. Convertisseur (2) pour un véhicule à entraînement électrique (1), comprenant
- trois modules à semi-conducteurs de puissance (5, 6, 7) comportant
(i) deux éléments de commutation et
(ii) un élément porteur (10), qui présente une face supérieure (11), sur laquelle des raccordements (12, 13, 14) sont disposés pour raccorder les éléments de commutation, une face inférieure opposée à la face supérieure (11) et des faces latérales, qui relient sur toute la périphérie la face supérieure (11) et la face inférieure, et
- un dispositif de refroidissement (8) comportant
(i) un canal de refroidissement (15), par lequel un fluide de refroidissement peut être amené le long de la face inférieure d'un élément porteur (10) respectif,
(ii) un dispositif récepteur (18), dans lequel les modules à semi-conducteurs de puissance (5, 6, 7) sont disposés côte à côte de telle sorte que des faces latérales d'une paire de modules à semi-conducteurs de puissance (5, 6, 7) adjacents se font face,
(iii) un dispositif d'étanchéité (19), qui empêche le fluide de refroidissement de s'échapper du dispositif de refroidissement (8), et
(iv) un dispositif de pression (20), qui exerce une force de pression sur le dispositif d'étanchéité (19) par serrage avec le dispositif récepteur (18),
**caractérisé en ce que**
le dispositif de refroidissement (8) comporte des dispositifs de support (25, 26), qui sont associés respectivement à l'une des paires et qui soutiennent la paire contre un fond (27) du canal de refroidissement (15) à application de la force de pression, **en ce que** chaque dispositif de support (25, 26) comporte plusieurs éléments de support (28) qui sont disposés le long des faces latérales opposées de la paire et qui s'étendent respectivement à l'intérieur du canal de refroidissement (15) depuis le fond (27) jusqu'aux faces inférieures de la paire, de sorte que respectivement deux éléments de support (28) adjacents et le fond (27) délimitent par sections des canaux de refroidissement partiel (29) du canal de refroidissement (15).

2. Convertisseur selon la revendication 1, en ce que les éléments de support (28) comportent respectivement un évidement (30) côté module à semi-conducteurs de puissance.

3. Convertisseur selon la revendication 1 ou 2, en ce que chaque dispositif de support (25, 26) comporte un élément de raccordement (34) raccordant côté module à semi-conducteurs de puissance les éléments de support, de sorte que les canaux de refroidissement partiel (29) sont délimités en plus par l'élément de raccordement (34).

4. Convertisseur selon les revendications 2 et 3, en ce que l'élément de raccordement (34) est inséré dans les évidements (30).

5. Convertisseur selon la revendication 3 ou 4, en ce que le dispositif d'étanchéité (19) est disposé sur l'élément de raccordement (34).

6. Convertisseur selon l'une des revendications 2 à 5, en ce que le dispositif d'étanchéité (19) est inséré dans les évidements (30).

7. Convertisseur selon l'une des revendications 1 à 4, en ce que le dispositif d'étanchéité (19) est disposé entre les modules à semi-conducteurs de puissance (5, 6, 7) et le dispositif de pression (20).

8. Convertisseur selon l'une des revendications précédentes, en ce que les éléments de support (28) sont reliés de manière solidaire au fond (27), en particulier formés d'un seul tenant avec le fond (27).

9. Convertisseur selon les revendications 1 à 6, en ce que les dispositifs de support (25, 26) sont formés d'un seul tenant avec le dispositif d'étanchéité (19).

10. Convertisseur selon l'une des revendications précédentes, en ce que le dispositif d'étanchéité (19) comporte une couche rigide, sur laquelle est disposée d'un côté ou des deux côtés une couche d'étanchéité élastique.

11. Convertisseur selon l'une des revendications précédentes, en ce que le dispositif d'étanchéité (19) comporte un joint solide ou un joint liquide durci.

12. Convertisseur selon l'une des revendications précédentes, en ce que le dispositif d'étanchéité (19) est formé comme élément d'étanchéité associé à un nombre de trous correspondant au nombre de modules à semi-conducteurs de puissance (5, 6, 7).

13. Convertisseur selon l'une des revendications précédentes, en ce que le fond (27) est formé par un évidement dans un boîtier (9) du convertisseur (2).
